# EUROPEAN PATENT SPECIFICATION

(11) **EP 1 315 976 B1**
(45) Date of publication and mention of the grant of the patent: **08.12.2004**
(21) Application number: 99936865.7
(22) Date of filing: 03.08.1999
(51) Int. Cl.: G01R 31/08, G01R 31/308

(54) **THERMOGRAPHIC WIRING INSPECTION**
THERMOGRAPHISCHE KABELPRÜFUNG
INSPECTION THERMOGRAPHIQUE DE CABLAGE

(43) Date of publication of application: 04.06.2003
(73) Proprietor: BAE SYSTEMS plc, Farnborough, Hampshire GU14 6YU (GB)
(72) Inventor: TULLOCH, John S. Dept. S415, Balderstone Lancashire BB2 7LF (GB); JENNINGS, Mark Christopher Dept. W427B, Preston Lancashire PR4 1AX (GB)
(74) Representative: MacLean, Martin David
(86) International application number: PCT/GB1999/002548
(87) International publication number: WO 2000/011484

(56) References cited:
- GB-A- 2 174 803
- US-A- 4 733 175
- PATENT ABSTRACTS OF JAPAN vol. 11, no. 378 (P-645), 10 December 1987 (1987-12-10) & JP 62 147350 A (KYOEI SANGYO), 1 July 1987 (1987-07-01)
- PATENT ABSTRACTS OF JAPAN vol. 8, no. 72 (P-265) [1509], 4 April 1984 (1984-04-04) & JP 58 216968 A (NIHON BOUSHIYOKU KOGYO), 16 December 1983 (1983-12-16)

## Description

This invention relates to the field of non-destructive testing and more particularly to the use of infra-red thermography in non-destructive testing of wires and cables.

For wires and cables intended to carry electrical current, it is generally desirable to be aware of any damage to insulation surrounding the wire or cable, such as cracks or cuts, before such damage can be propagated further. Damage to insulation surrounding wires may eventually result in the wire being exposed to the environment, potentially resulting in a short circuit which may cause the wire to fail or may cause a fire. These potential outcomes are clearly unacceptable, particularly where the wire is carrying current to critical items of equipment or where a fire may be difficult to detect and eliminate, for example, in an aircraft.

It is common practice to test cables or wires, particularly those which have been newly installed, by powering them up and checking that the equipment to which they are connected is functioning. This indicates whether the wire or cable is capable of conducting current, but gives no indication however of the extent of any damage to the wire or insulation which may subsequently cause the wire to fail.

Visual checks of wires and cables are a usual practice in the aircraft industry, particularly in planned maintenance or when damage to the insulation of a cable or wire is suspected, for example, following exposure to higher temperatures than usual. Visual checks can only show damage on the outside surfaces of insulation of a wire or cable and it may be difficult to tell, without removing the wire or cable from an installation, the true extent of the damage. Also where several cables are bundled together into a loom, it can be very difficult to see damage on the insulation of a cable which is surrounded by other cables.

JP-A-58216968 discloses the quality testing of cable insulation by measuring the potential difference between the inner and outer conductors of a coaxial cable connected to a reference electrode in an electrolyte.

The testing of pre-installed wires and cables, including their terminations, using non-destructive infra-red thermography techniques is known to a limited extent in various industries. One known method as described in GB-A-2174803 is to apply a current to a pre-installed wire or cable and use an infra-red detector to determine the thermal energy emanating from the wire or cable along its length. In regions where the insulation of the wire is intact, the thermal emissions are lower than for areas with insulation damage. The amount of heat radiated by the wire and detected by the detector is proportional to the thickness of the insulator, and so it is possible to determine how badly damaged the wire insulation is in one region from the amount of heat radiated from that region compared to that radiated from the rest of the wire. In this way, partially damaged insulation in wires can be detected and monitored in use to see whether the damage is becoming worse, and the insulation may be changed or repaired before the wire fails.

If a detector were merely pointed at the wire, it may readily detect heat emanating from the part of the circumference to which it had a direct line of sight but any damage on the other part of the circumference would not be so easily detected. Accordingly the known techniques generally involve positioning infra-red detection apparatus around the wire being tested and moving the apparatus along the length of the wire. Positioning detection apparatus around the outer circumference of the wire allows thermal energy emanating from any point on the circumference to be detected.

This technique however has several disadvantages, for example, it is not always possible to position detection apparatus around a wire, for example, when the wires or cables are fixed to run along a wall or when there is little room for detection apparatus or its installation, for example, in the avionics bay of an aircraft. Furthermore it may be difficult to use the detector to locate damage to wires in the centre of a bundle, as the surrounding wires may act as a shield and inhibit temperature variations at that location.

The present invention seeks to overcome these problems and provide a more accurate method of determining the extent of damage to the insulation of wires and cables than hitherto known.

According to the present invention there is provided a method for inspecting the integrity of the insulation of a wire or cable including the steps of:
passing a current through said wire or cable;
applying to said wire or cable a fluid having electrolytic properties and of a type that causes no substantial degradation of elastomeric polymer insulation around said wires or cables, and
using a thermal imaging system to detect and display the intensity of heat emanating from said wire or cable.

Those regions of the wire or cable having substantially greater intensity of heat emanating therefrom than adjacent regions of the wire or cable are thereby advantageously identified.

The thermal imaging system advantageously comprises an infra-red detector and a display monitor, said monitor being capable of displaying images.

The thermal imaging system may further include recording means for recording displayed images.

The infra-red detector is preferably a thermal imaging camera. The infra-red detector may be hand held or alternatively it may be stand mounted. The infra-red detector is preferably capable of detecting temperature changes of less than 0.5°C.

The recording means may be adapted to allow images to be stored on computer disks. Alternatively the recording means may be adapted to allow images to be stored on video tape.

The images may be displayed as calibrated spacial thermal images. Preferably a false colour scale is used to represent various temperatures.

The fluid applied to the insulation preferably is capable of conducting a leakage current between sites where there is damage to the insulation. Leakage current measuring means such as an ammeter, or an oscilloscope, for example, may further be provided for measuring this current. Heat is advantageously dissipated on conduction of the leakage current by the fluid, so that where a wire has damaged insulation, a higher temperature is detected in the region of the damage.

Advantageously, damage sites within a bundle of wires or on a substantially inaccessible part of a wire or cable may be detected due to the leakage current being conducted by the fluid away from an immediate damage site.

The fluid may be an aqueous saline solution, preferably containing sodium chloride in the range 1% to 3% by mass. The fluid may alternatively contain ammonium chloride in the range 1% to 3% by mass. Advantageously the fluid contains 2% sodium chloride by mass.

The fluid may be dripped or sprayed on to the wires, cables or bundle of wires to be inspected. The fluid preferably includes a wetting agent, such as, for example, "Triton X100" for reducing the surface tension of the fluid and thereby preventing large droplets from forming, so that the fluid is capable of spreading over a surface on to which it is applied. The wetting agent thereby allows the fluid to advantageously spread around a wire or cable to be inspected and, for bundles of cables, the fluid may permeate through the bundle so that the insulating materials around the individual wires within the bundle are wet.

The fluid is preferably non-corrosive.

Advantageously, the thermal imaging system is further used to detect and display the intensity of heat emanating from the wire or cable prior to the application of the fluid, to provide datum values of heat emission. Preferably the amount of fluid used is then dependent upon these datum values and the distance between suspected damage sites. Fluid may be addded gradually as too much fluid can result in a short circuit, which may cause damage to equipment.

After the application of fluid to the insulation of a bundle of wires, such as a loom within an aircraft for example, the thermal image may be monitored for several minutes. As the fluid dries, the heat emanating from a damaged site may decrease substantially as the fluid becomes less able to conduct a leakage current. The fluid preferably conducts a leakage current between adjacent damage sites, and thereby enhances the intensity of heat emanating from a wire having a damaged insulator, thus allowing damage to the insulation to be more easily detected.

This method may advantageously be applied to the inspection of installed bundles of insulated wires, known as looms on aircraft. Areas of damage to insulation may preferably be detected prior to critical failure, and areas prone to failure may be monitored and the results assessed regularly to look for the onset of damage or to monitor the evolution of known damage.

It will be recognised by one skilled in the art that this method may be applied to the detection of insulation damage in any wires or cables, and is not limited to those on aircraft.

In order to more fully understand the present invention, the following embodiments are described by way of example only and with reference to the accompanying drawings in which:
Figures 1a and 1b show schematic plan views of apparatus used in two steps of a method according to the present invention;
Figure 2 shows a plan view of a loom conducting current and a corresponding display of heat emanating from the wire both with and without the electrolytic fluid; and
Figure 3 shows a flow chart of a preferred method in accordance with the present invention.

Figure la shows a loom 1, comprising several cables 2, which form part of the avionics system of an aircraft (not shown). The loom 1 is connected to form part of an electrical circuit 3 for allowing either alternating or direct current to flow through the cables 2. An infra-red thermal imaging system 4 is shown, which comprises an infra-red thermal imaging camera 5, a display monitor 6 and a video recorder 7. The camera 5 is connected to the display monitor 6 by cables 8. The monitor 6 is for displaying the thermal images detected by the camera 5 and these images may then be recorded by the video recorder 7, which is connected to the monitor 6 by cables 9.

In operation, the loom is connected to an electrical circuit which is then switched on. As current flows through the loom 1, heat is dissipated by the cables 2 and this is detected by the camera 5 and displayed on the monitor 6 as a thermal image. The camera 5 is slowly moved along the loom 1 so as to detect the intensity of heat emanating from the cables 2 along the loom 1. The monitor 6 displays the intensity of heat emanating from the wire along the length of the wire as a graphical image, providing datum values.

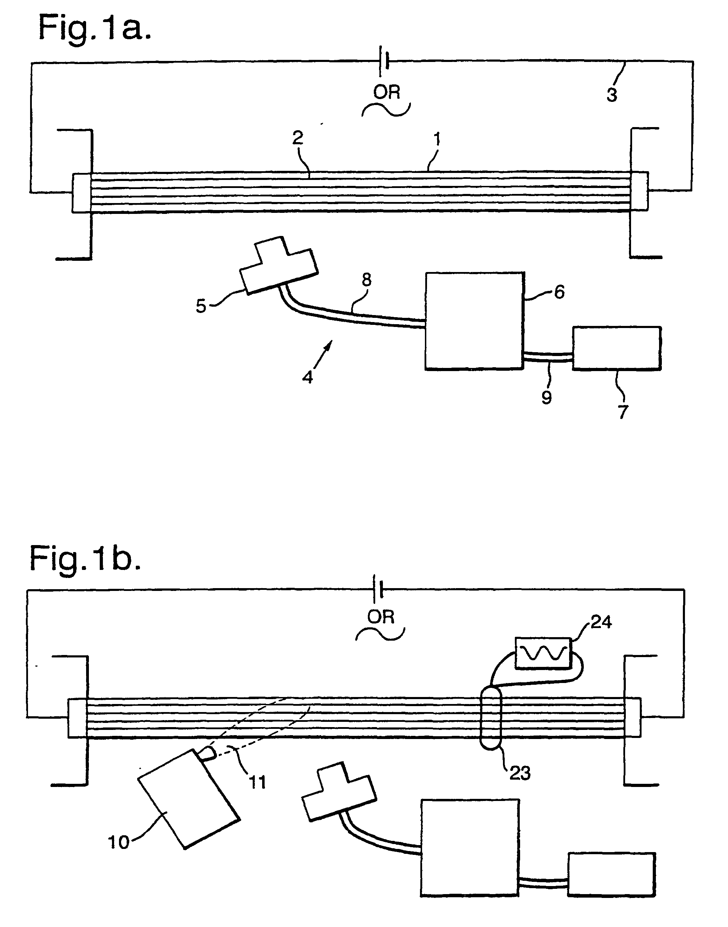

The next step of the method is described in Figure 1b, and is advantageous in detecting areas of a loom which may be damaged but which are deep within the loom or are positioned against a structure such as a wall of an aircraft fuselage.

Figure 1b shows the same apparatus as that shown in Figure 1a, with the addition of a spray dispenser 10, a current clamp ammeter 23 and an oscilloscope 24. The dispenser 10 contains an electrolytic fluid 11 comprising 2% sodium chloride by mass and the wetting agent known as "Triton X100". This fluid 11 is sprayed on to the cables 2 of the loom 1 where it permeates around them wetting their outer insulation. The current clamp ammeter 23 is in contact with the loom 1 and the oscilloscope 24. The oscilloscope 24 is for displaying leakage current values.

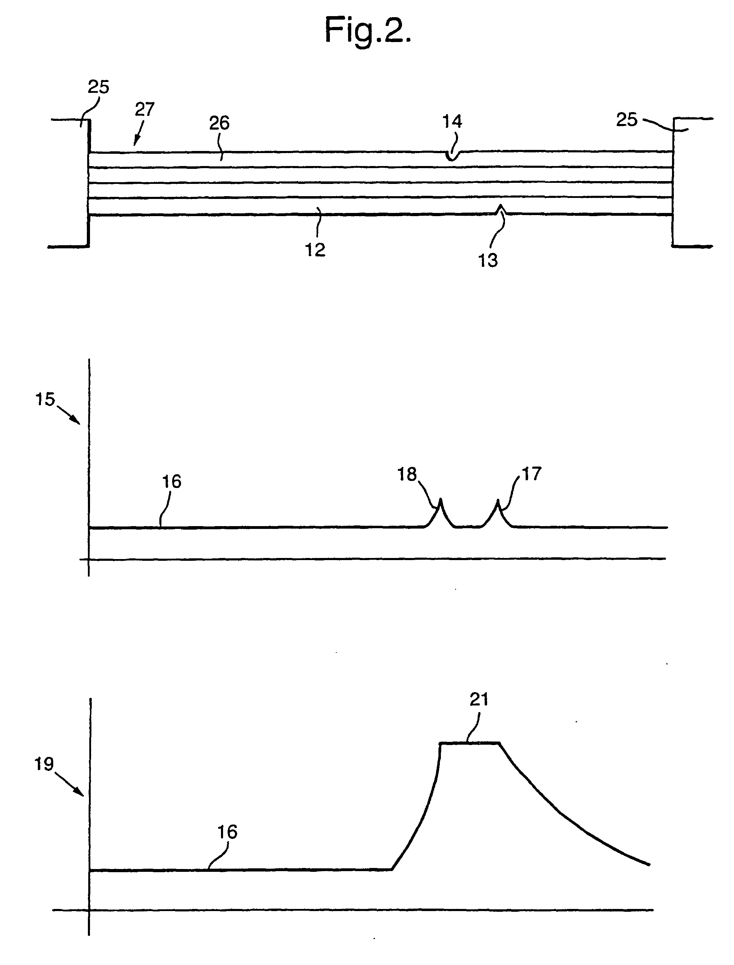

When an electrical current is applied to the loom 1 after addition of the fluid 11, the leakage current escaping from any damage sites along the loom 1 will be conducted by the fluid 11 around the cables 2 and the loom 1 to an adjacent damage site, such that the leakage current may be detected around the circumference of the loom by the infra-red thermal imaging camera or by the current clamp ammeter 23. The leakage current may also be detected at sites adjacent the damage site as shown in Figure 2.

Figure 2 shows a loom 27 comprising insulated wires 12, 26 positioned between a pair of connectors 25 and conducting current therebetween. Part of the insulation of the wire 12 is damaged around its circumference 13, possibly caused by the wire 12 being tied or clipped to other wires or to a structure (not shown) at that point. The wire 26 has a radial crack 14 in its insulation, possibly caused by impact from a tool (not shown) during installation of the wire.

A graph 15 of intensity of heat versus distance along the loom 27 prior to the addition of an electrolyte is shown as it might appear on the display apparatus. Where the insulation of the wire 12 is undamaged, the heat intensity is at a datum level 16. Where the insulation of the wires 12, 26 have been damaged 13, 14, small peaks 17, 18 may be displayed corresponding to heat emanating from the wires 12, 26 due to the damaged insulation. Where the damage is hidden from direct view of the camera, no peaks may occur.

A graph 19 of intensity of heat versus distance along the loom27 following the addition of an electrolyte (as shown in Figure 1) is shown as it might appear on the display monitor. Where the insulation of the wires 12, 26 is undamaged the heat intensity is at a datum level 16. Where the insulation of the wires 12, 26 has been damaged at 14, a rapid temperature increase is displayed, and a higher temperature plateau 21 is shown between damage sites 13 and 14, corresponding to the heat emanating from the wires 12, 26 due to the damaged insulation and the conduction of the leakage current from the damage site 13 to adjacent damage site 14 via the electrolyte. Particularly where damage is located out of the line of sight of the detector, the addition of the electrolyte allows the leakage current to flow around the insulated wire between damage sites and so enables hidden damage sites to be detected.

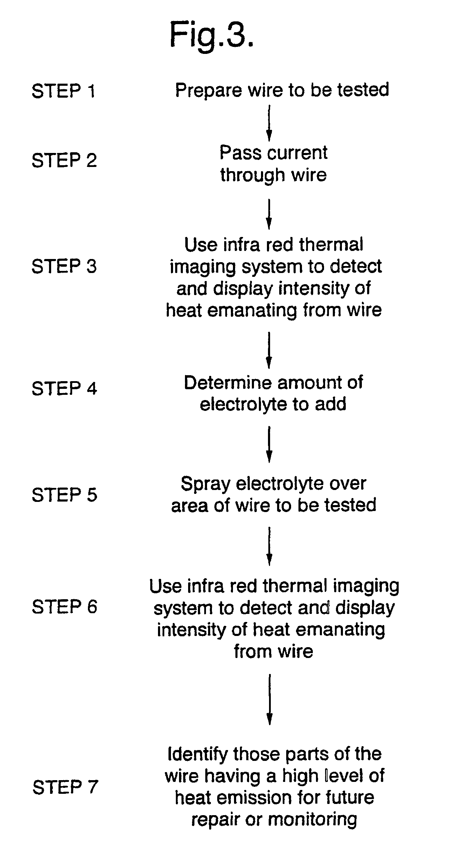

Figure 3 shows the sequence of operations in a preferred method of detecting damage to insulation of wires. The sequence proceeds in the direction of the arrows.

First a wire is connected as shown in Figure 1 and a current is passed through it (steps 1 and 2). A camera capable of infra-red detection (as shown in Figure 1) is moved along the length of the wire and a graph of heat intensity versus distance along the wire (as shown in Figure 2) is displayed on a monitor (step 3).

In step 4 the display is used to establish datum values of heat emission from the wire and also gives an indication of the extent of any damage. The amount of electrolyte to be sprayed on to the wire is dependent upon the datum values of heat emission and the proximity of adjacent damage sites, as too much electrolyte could cause a short circuit and too little may not allow a leakage current to flow between adjacent damage sites, and so damage may not be detected in areas of the wire hidden from direct view.

At step 5 the electrolyte is then sprayed on to the wire, so that the insulation is wetted around the circumference of the wire. The camera is again passed over the length of the wire or is focused on particular areas of interest, according to requirement, and the result is displayed on the monitor (step 6).

The addition of the electrolyte allows a leakage current to flow between adjacent damage sites and so enhances the detection of heat emanating from damaged sites and can allow detection of damaged sites undetectable without the electrolyte (step 7). Those sites identified as having damaged insulation can then be noted for future repair or can be monitored to see if this damage becomes worse.

## Claims

1. A method for inspecting the integrity of the insulation of a wire or cable including the steps of:
passing a current through said wire or cable;
applying to said wire or cable a fluid having electrolytic properties and of a type that causes no substantial degradation of elastomeric polymer insulation around said wires or cables, and
using a thermal imaging system to detect and display the intensity of heat emanating from said wire or cable.

2. A method for inspecting the integrity of the insulation of a wire or cable as claimed in claim 1 wherein the thermal imaging system comprises an infra-red detector and a display monitor.

3. A method for inspecting the integrity of the insulation of a wire or cable as claimed in claim 1 or claim 2 wherein recording means are provided for recording images displayed by the thermal imaging system.

4. A method for inspecting the integrity of the insulation of a wire or cable as claimed in claim 2 wherein the infra-red detector is a thermal imaging camera.

5. A method for inspecting the integrity of the insulation of a wire or cable as claimed in claim 2 or claim 4 wherein the infra-red detector is hand held.

6. A method for inspecting the integrity of the insulation of a wire or cable as claimed in claim 2 or claim 4 wherein the infra-red detector is stand mounted.

7. A method for inspecting the integrity of the insulation of a wire or cable as claimed in claim 2 or as claimed in any one of claims 4 to 6 wherein said infra-red detector is capable of detecting temperature changes of less than 0.5°C.

8. A method for inspecting the integrity of the insulation of a wire or cable as claimed in claim 3 wherein said recording means is adapted to allow displayed images to be stored on computer disks.

9. A method for inspecting the integrity of the insulation of a wire or cable as claimed in claim 3 wherein said recording means is adapted to allow images to be stored on video tape.

10. A method for inspecting the integrity of the insulation of a wire or cable as claimed in claim 3 wherein said images are displayed as calibrated spacial thermal images.

11. A method for inspecting the integrity of the insulation of a wire or cable as claimed in claim 3 wherein a false colour scale is used to represent various temperatures on displayed images.

12. A method for inspecting the integrity of the insulation of a wire or cable as claimed in any preceding claim wherein said fluid is capable of conducting a leakage current.

13. A method for inspecting the integrity of the insulation of a wire or cable as claimed in claim 12 wherein leakage current measuring means are provided to measure said leakage current.

14. A method for inspecting the integrity of the insulation of a wire or cable as claimed in claim 13, wherein said leakage current measuring means comprises an ammeter.

15. A method for inspecting the integrity of the insulation of a wire or cable as claimed in claim 13, whereas said leakage current measuring means comprises an oscilloscope.

16. A method for inspecting the integrity of the insulation of a wire or cable as claimed in any preceding claim wherein said fluid is an aqueous saline solution.

17. A method for inspecting the integrity of the insulation of a wire or cable as claimed in any preceding claim wherein said fluid comprises sodium chloride in the range 1 to 3% by mass.

18. A method for inspecting the integrity of the insulation of a wire or cable as claimed in any preceding claim wherein said fluid comprises 2% sodium chloride by mass.

19. A method of inspecting the integrity of the insulation of a wire or cable as claimed in any one of claims 1 to 15 wherein said fluid comprises ammonium chloride in the range 1 to 3% by mass.

20. A method for inspecting the integrity of the insulation of a wire or cable as claimed in any preceding claim wherein said fluid is dripped on to the wire or cable.

21. A method for inspecting the integrity of the insulation of a wire or cable as claimed in any one of claims 1 to 19 wherein said fluid is sprayed on to the wire or cable.

22. A method for inspecting the integrity of the insulation of a wire or cable as claimed in any preceding claim wherein said fluid includes a wetting agent, said wetting agent being capable of reducing the surface tension of the fluid and thereby preventing large droplets from forming.

23. A method for inspecting the integrity of the insulation of a wire or cable as claimed in any preceding claim wherein said fluid is non-corrosive.

24. A method for inspecting the integrity of the insulation of a wire or cable as claimed in any preceding claim wherein said thermal imaging system is used to detect and display the intensity of heat emanating from the wire or cable prior to the application of said fluid, to provide datum values of heat emission.

25. A method for inspecting the integrity of the insulation of a wire or cable as claimed in claim 24 wherein the amount of fluid used is dependent upon said datum values.

## Patentansprüche

1. Verfahren zur Prüfung der Unversehrtheit der Isolation eines Drahtes oder eines Kabels mit den folgenden Schritten:
es wird ein Strom durch den Draht oder das Kabel geschickt;
es wird auf den Draht oder das Kabel ein Fluid aufgetragen, das elektrolytische Eigenschaften besitzt und so beschaffen ist, dass es keine wesentliche Verschlechterung der elastomeren polymeren Isolation um die Drähte oder Kabel herum bewirkt, und
es wird ein thermisches Abbildungssystem benutzt, um die Wärmeintensität, die aus dem Draht oder Kabel austritt, zu detektieren und darzustellen.

2. Verfahren zur Prüfung der Unversehrtheit der Isolation eines Drahtes oder Kabels nach Anspruch 1, bei welchem das thermische Abbildungssystem einen Infrarotdetektor und einen Anzeigemonitor aufweist.

3. Verfahren zur Prüfung der Unversehrtheit der Isolation eines Drahtes oder Kabels nach den Ansprüchen 1 oder 2, bei welchem Aufzeichnungsmittel vorgesehen sind, um Bilder aufzuzeichnen, die durch das thermische Abbildungssystem dargestellt werden.

4. Verfahren zur Prüfung der Unversehrtheit der Isolation eines Drahtes oder Kabels nach Anspruch 2, bei welchem der Infrarotdetektor eine thermische Bildkamera ist.

5. Verfahren zur Prüfung der Unversehrtheit der Isolation eines Drahtes oder Kabels nach den Ansprüchen 2 oder 4, bei welchem der Infrarotdetektor ein tragbarer Handdetektor ist.

6. Verfahren zur Prüfung der Unversehrtheit der Isolation eines Drahtes oder Kabels nach den Ansprüchen 2 oder 4, bei welchem der Infrarotdetektor ein Stativapparat ist.

7. Verfahren zur Prüfung der Unversehrtheit der Isolation eines Drahtes oder Kabels nach Anspruch 2 oder nach einem der Ansprüche 4 bis 6, bei welchem der Infrarotdetektor in der Lage ist, Temperaturänderungen von weniger als 0,5°C festzustellen.

8. Verfahren zur Prüfung der Unversehrtheit der Isolation eines Drahtes oder Kabels nach Anspruch 3, bei welchem die Aufzeichnungsmittel die Speicherung der dargestellten Bilder auf Computerdisks ermöglichen.

9. Verfahren zur Prüfung der Unversehrtheit der Isolation eines Drahtes oder Kabels nach Anspruch 3, bei welchem die Aufzeichnungsmittel die Speicherung der Bilder auf Videoband ermöglichen.

10. Verfahren zur Prüfung der Unversehrtheit der Isolation eines Drahtes oder Kabels nach Anspruch 3, bei welchem die Bilder als kalibrierte räumliche Wärmebilder dargestellt werden.

11. Verfahren zur Prüfung der Unversehrtheit der Isolation eines Drahtes oder Kabels nach Anspruch 3, bei welchem eine Falschfarbskala benutzt wird, um die verschiedenen Temperaturen auf den dargestellten Bildern zu repräsentieren.

12. Verfahren zur Prüfung der Unversehrtheit der Isolation eines Drahtes oder Kabels nach einem der vorhergehenden Ansprüche, bei welchem das Fluid in der Lage ist, einen Leckstrom zu leiten.

13. Verfahren zur Prüfung der Unversehrtheit der Isolation eines Drahtes oder Kabels nach Anspruch 12, bei welchem eine Leckstrom-Messeinrichtung vorgesehen ist, um den Leckstrom zu messen.

14. Verfahren zur Prüfung der Unversehrtheit der Isolation eines Drahtes oder Kabels nach Anspruch 13, bei welchem die Leckstrom-Messeinrichtung aus einem Amperemeter besteht.

15. Verfahren zur Prüfung der Unversehrtheit der Isolation eines Drahtes oder Kabels nach Anspruch 13, bei welchem die Leckstrom-Messeinrichtung aus einem Oszilloskop besteht.

16. Verfahren zur Prüfung der Unversehrtheit der Isolation eines Drahtes oder Kabels nach einem der vorhergehenden Ansprüche, bei welchem das Fluid eine wässrige Salzlösung ist.

17. Verfahren zur Prüfung der Unversehrtheit der Isolation eines Drahtes oder Kabels nach einem der vorhergehenden Ansprüche, bei welchem das Fluid Natriumchlorid in einem Bereich zwischen 1 bis 3 Massenprozent aufweist.

18. Verfahren zur Prüfung der Unversehrtheit der Isolation eines Drahtes oder Kabels nach einem der vorhergehenden Ansprüche, bei welchem das Fluid 2 Massenprozent Natriumchlorid enthält.

19. Verfahren zur Prüfung der Unversehrtheit der Isolation eines Drahtes oder Kabels nach einem der Ansprüche 1 bis 15, bei welchem das Fluid Ammoniumchlorid in einem Bereich zwischen 1 bis 3 Massenprozent aufweist.

20. Verfahren zur Prüfung der Unversehrtheit der Isolation eines Drahtes oder Kabels nach einem der vorhergehenden Ansprüche, bei welchem das Fluid auf den Draht oder das Kabel geträufelt wird.

21. Verfahren zur Prüfung der Unversehrtheit der Isolation eines Drahtes oder Kabels nach einem der Ansprüche 1 bis 19, bei welchem das Fluid aufgesprüht wird.

22. Verfahren zur Prüfung der Unversehrtheit der Isolation eines Drahtes oder Kabels nach einem der vorhergehenden Ansprüche, bei welchem das Fluid ein Netzmittel enthält und das Netzmittel in der Lage ist, die Oberflächenspannung des Fluids zu vermindern und dadurch die Bildung großer Tropfen verhindert.

23. Verfahren zur Prüfung der Unversehrtheit der Isolation eines Drahtes oder Kabels nach einem der vorhergehenden Ansprüche, bei welchem das Fluid nicht korrodierend ist.

24. Verfahren zur Prüfung der Unversehrtheit der Isolation eines Drahtes oder Kabels nach einem der vorhergehenden Ansprüche, bei welchem das thermische Abbildungssystem benutzt wird, um die Wärmeintensität zu detektieren und darzustellen, die aus dem Draht oder dem Kabel austritt, bevor das Fluid aufgebracht wird, um Bezugswerte der Wärmeemission zu schaffen.

25. Verfahren zur Prüfung der Unversehrtheit der Isolation eines Drahtes oder Kabels nach Anspruch 24, bei welchem die benutzte Fluidmenge abhängig ist von den Bezugswerten.

## Revendications

1. Un procédé d'inspection de l'intégrité de l'isolation d'un fil métallique ou d'un câble comprenant les étapes de :
faire passer un courant au travers dudit fil métallique ou câble ;
appliquer sur ledit fil métallique ou câble un fluide ayant des propriétés électrolytiques et d'un type qui ne provoque aucune dégradation substantielle de l'isolation polymère élastomère autour desdits fils métalliques ou câbles, et
utiliser un système de thermographie pour détecter et afficher l'intensité de la chaleur émanant dudit fil métallique ou câble.

2. Un procédé d'inspection de l'intégrité de l'isolation d'un fil métallique ou d'un câble tel que revendiqué dans la revendication 1 dans lequel le système de thermographie comporte un détecteur infrarouge et un moniteur d'affichage.

3. Un procédé d'inspection de l'intégrité de l'isolation d'un fil métallique ou d'un câble tel que revendiqué dans la revendication 1 ou la revendication 2 dans lequel des moyens d'enregistrement sont fournis pour enregistrer des images affichées par le système de thermographie.

4. Un procédé d'inspection de l'intégrité de l'isolation d'un fil métallique ou d'un câble tel que revendiqué dans la revendication 2 dans lequel le détecteur infrarouge est une caméra thermique.

5. Un procédé d'inspection de l'intégrité de l'isolation d'un fil métallique ou d'un câble tel que revendiqué dans la revendication 2 ou la revendication 4 dans lequel le détecteur infrarouge est à main.

6. Un procédé d'inspection de l'intégrité de l'isolation d'un fil métallique ou d'un câble tel que revendiqué dans la revendication 2 ou la revendication 4 dans lequel le détecteur infrarouge est sur pied.

7. Un procédé d'inspection de l'intégrité de l'isolation d'un fil métallique ou d'un câble tel que revendiqué dans la revendication 2 ou tel que revendiqué dans n'importe laquelle des revendications 4 à 6 dans lequel ledit détecteur infrarouge est capable de détecter des changements de température de moins de 0,5 °C.

8. Un procédé d'inspection de l'intégrité de l'isolation d'un fil métallique ou d'un câble tel que revendiqué dans la revendication 3 dans lequel ledit moyen d'enregistrement est adapté pour permettre à des images affichées d'être stockées sur des disques informatiques.

9. Un procédé d'inspection de l'intégrité de l'isolation d'un fil métallique ou d'un câble tel que revendiqué dans la revendication 3 dans lequel ledit moyen d'enregistrement est adapté pour permettre à des images d'être stockées sur des bandes vidéo.

10. Un procédé d'inspection de l'intégrité de l'isolation d'un fil métallique ou d'un câble tel que revendiqué dans la revendication 3 dans lequel lesdites images sont affichées sous forme d'images thermiques spatiales calibrées.

11. Un procédé d'inspection de l'intégrité de l'isolation d'un fil métallique ou d'un câble tel que revendiqué dans la revendication 3 dans lequel une fausse échelle des couleurs est utilisée pour représenter diverses températures sur des images affichées.

12. Un procédé d'inspection de l'intégrité de l'isolation d'un fil métallique ou d'un câble tel que revendiqué dans n'importe quelle revendication précédente dans lequel ledit fluide est capable de conduire un courant de fuite.

13. Un procédé d'inspection de l'intégrité de l'isolation d'un fil métallique ou d'un câble tel que revendiqué dans la revendication 12 dans lequel des moyens de mesure de courant de fuite sont fournis pour mesurer ledit courant de fuite.

14. Un procédé d'inspection de l'intégrité de l'isolation d'un fil métallique ou d'un câble tel que revendiqué dans la revendication 13, dans lequel ledit moyen de mesure de courant de fuite comporte un ampèremètre.

15. Un procédé d'inspection de l'intégrité de l'isolation d'un fil métallique ou d'un câble tel que revendiqué dans la revendication 13, dans lequel ledit moyen de mesure de courant de fuite comporte un oscilloscope.

16. Un procédé d'inspection de l'intégrité de l'isolation d'un fil métallique ou d'un câble tel que revendiqué dans n'importe quelle revendication précédente dans lequel ledit fluide est une solution saline aqueuse.

17. Un procédé d'inspection de l'intégrité de l'isolation d'un fil métallique ou d'un câble tel que revendiqué dans n'importe quelle revendication précédente dans lequel ledit fluide comporte du chlorure de sodium dans la gamme allant de 1 à 3 % par masse.

18. Un procédé d'inspection de l'intégrité de l'isolation d'un fil métallique ou d'un câble tel que revendiqué dans n'importe quelle revendication précédente dans lequel ledit fluide comporte 2 % de chlorure de sodium par masse.

19. Un procédé d'inspection de l'intégrité de l'isolation d'un fil métallique ou d'un câble tel que revendiqué dans n'importe laquelle des revendications 1 à 15 dans lequel ledit fluide comporte du chlorure d'ammonium dans la gamme allant de 1 à 3 % par masse.

20. Un procédé d'inspection de l'intégrité de l'isolation d'un fil métallique ou d'un câble tel que revendiqué dans n'importe quelle revendication précédente dans lequel ledit fluide est amené à tomber goutte à goutte sur le fil métallique ou le câble.

21. Un procédé d'inspection de l'intégrité de l'isolation d'un fil métallique ou d'un câble tel que revendiqué dans n'importe laquelle des revendications 1 à 19 dans lequel ledit fluide est vaporisé sur le fil métallique ou le câble.

22. Un procédé d'inspection de l'intégrité de l'isolation d'un fil métallique ou d'un câble tel que revendiqué dans n'importe quelle revendication précédente dans lequel ledit fluide comprend un agent mouillant, ledit agent mouillant étant capable de réduire la tension superficielle du fluide et d'empêcher de ce fait que de grosses gouttelettes ne se forment.

23. Un procédé d'inspection de l'intégrité de l'isolation d'un fil métallique ou d'un câble tel que revendiqué dans n'importe quelle revendication précédente dans lequel ledit fluide est non corrosif.

24. Un procédé d'inspection de l'intégrité de l'isolation d'un fil métallique ou d'un câble tel que revendiqué dans n'importe quelle revendication précédente dans lequel ledit système de thermographie est utilisé pour détecter et afficher l'intensité de la chaleur émanant du fil métallique ou du câble avant l'application dudit fluide, pour fournir des valeurs de référence d'émission de chaleur.

25. Un procédé d'inspection de l'intégrité de l'isolation d'un fil métallique ou d'un câble tel que revendiqué dans la revendication 24 dans lequel la quantité de fluide utilisée dépend desdites valeurs de référence.
